# EUROPEAN PATENT APPLICATION

(11) **EP 4 564 418 A1**
(43) Date of publication of application: **04.06.2025**
(21) Application number: 23212987.4
(22) Date of filing: 29.11.2023
(51) Int. Cl.: H01L 23/31, H01L 23/495, H01L 21/48, H01L 21/56

(54) **SEMICONDUCTOR PACKAGE**

(71) Applicant: Nexperia B.V., 6534 AB Nijmegen (NL)
(72) Inventor: Hor, Wai Hung William, Hong Kong (HK); Lam, Kan Wae, Nijmegen (NL); Flauta, Randolph Estal, Hong Kong (HK); Leung, Chi Ho, Hong Kong (HK)
(74) Representative: Pjanovic, Ilija

(57) **Abstract**

There is disclosed a semiconductor package for a PCB. The semiconductor package comprises: a die paddle; a die; a plurality of terminals and an encapsulant. The die is coupled to the die paddle. The plurality of terminals are electrically connected to the die. The plurality of terminals comprise a first array of terminals, disposed along a first side of the semiconductor package, and a second array of terminals, disposed along a second side of the semiconductor package. The second side opposes the first side. Each of the plurality of terminals comprises a pad with a flank. The encapsulant at least partly surrounds the die. The recess is defined between each terminal of each of the first and second arrays of terminals.

## Description

The present invention relates to a semiconductor package, a method of manufacturing a batch of semiconductor packages, and an array of semiconductor packages.

Semiconductor packages, such as transistors, are manufactured as layered assemblies including components such as die paddles (e.g. thermal pads), dies (e.g. chips), leads (e.g. tracks) and an encapsulant (e.g. casing).

The leads of the semiconductor package, with multiple leads typically being electrically connected to the die, define pads (e.g. contacts) by which the semiconductor package is electrically connectable to a printed circuit board (PCB). In typical applications it is only by virtue of the pads that the entire semiconductor package is coupled to the PCB. This is usually by way of a soldered connection. In many applications, such as in the automotive sector, it is desirable to inspect the soldered joint, as part of a quality control process, to confirm that the semiconductor package is robustly connected to the PCB. An issue encountered with current processes is that a thickness of the solder between the semiconductor package pad and the corresponding PCB pad is typically very thin (e.g. of the order of around 10 microns). Inspection of the soldered joint using Automated Optical Inspection (AOI) from the top (e.g. plan) view at this scale presents a real challenge.

There exists a need to overcome the disadvantages associated with existing semiconductor packages, and associated methods of manufacture, whether mentioned in this document or otherwise.

According to a first aspect of the invention there is provided a semiconductor package for a PCB, comprising:
a die paddle;
a die coupled to the die paddle;
a plurality of terminals electrically connected to the die, the plurality of terminals comprising a first array of terminals, disposed along a first side of the semiconductor package, and a second array of terminals, disposed along a second side of the semiconductor package, wherein the second side opposes the first side, each of the plurality of terminals comprising a pad with a flank; and
an encapsulant which at least partly surrounds the die; wherein
a recess is defined between each terminal of each of the first and second arrays of terminals.

The semiconductor package may otherwise be described as a semiconductor assembly. The semiconductor package may be a diode, transistor, a combination of diodes and/or transistors, or other semiconductor device.

The die paddle may otherwise be described as a plate of conductive material. The die paddle may be manufactured from a copper alloy or entirely from copper. The die paddle may be described as a thermal pad. The die paddle may consist of a single body, or may comprise a plurality of portions (e.g. a multi-part, or multi-piece, die paddle). The die paddle may have a variable thickness (e.g. incorporate one or more projecting features).

The die may be a single component or may comprise multiple constituent components. The die is preferably coupled to the die paddle using solder. The die being coupled to the die paddle may otherwise be described as the die being attached to the die paddle. The die may be described as being bonded to the die paddle. The die may be a silicon chip.

The terminals may be described as 10 terminals. Each terminal may be described as a leg. Each terminal may comprise a pad, for attachment to a PCB. Each terminal may be at least partly defined by a block.

In some embodiments a first plurality of leads may extend from the first side of a die and then only a second plurality of leads may extend from a second, opposing side. Put another way, the third and four sides of the die may be absent of any leads. This may be described as a two-sided configuration.

A flank which is suitable for having solder applied to it may be referred to as a side-wettable flank (SWF). The flank preferably has a thickness of around 100 microns. This may be achievable when a thickness of the lead frame array, and die paddle, is around 102 microns.

The encapsulant may otherwise be described as a casing or shield. The encapsulant may be described as encapsulating the die. The encapsulant advantageously reduces the risk of contaminants, such as moisture, penetrating into the semiconductor package. The encapsulant preferably extends between first and second major faces of the die paddle. The encapsulant may be plastic. The encapsulant may otherwise be described as being manufactured from a polymer. The encapsulant is preferably manufactured using an injection moulding process where an at least partially molten material is moulded into the desired encapsulant shape. The encapsulant may otherwise be manufactured using a transfer moulding, or compression moulding, process. The encapsulant may be a thermoplastic (e.g. a thermosetting polymer). The encapsulant may fully surround the die.

In some embodiments, the die paddle may be constituted by the plurality of terminals. That is to say, in some embodiments the die may be coupled directly to the plurality of terminals. In such embodiments, the electrical connection of the plurality of terminals to the die may be provided by virtue of the die being (electrically) coupled to the terminals. Described a further different way, in some embodiments the die paddle is not a separate component to the terminals, but the terminals provide the die paddle functionality.

Advantageously, the recesses mean the terminals effectively project from the encapsulant, so inspection of the solder joint from a top-down view (e.g. using an Automated Optical Inspection [AOI]) is easier. Furthermore, the joint can be inspected from multiple different orientations of the flank (e.g. above, from the side etc.)

Each pad and flank may be exposed through the encapsulant.

The pad and flank being exposed may mean the pad and flank are flush with the surrounding encapsulant (but visible). The pad and flank being exposed may mean the pad and flank projects through the surrounding encapsulant (i.e. a protruding feature).

Advantageously, the pad and flank being exposed through the encapsulant means inspection is easier.

Each recess may be a stepped recess.

Each recess preferably extends across an entire extent of a height of the semiconductor package.

Each recess may extend from a first terminal of the adjacent pair of terminals to a second terminal of the adjacent pair of terminals.

Put another way, the recess extends entirely between adjacent terminals.

One or more of the terminals may comprise a metal plating, the metal plating extending at least partway across the pad and the flank.

The metal plating may otherwise be described as a metal layer. The metal plating may comprise one or more of tin or silver. The metal plating extending at least partway across a flank is intended to encompass the metal plating extending at least partway along a non-horizontal surface of the pad. For example, if the pad defines an underside and also has an associated height, the height may be described as defining a flank. The metal plating may extend across an entire extent of one or more pads and flanks. The metal plating may extend across an entire extent of each of the pads and flanks.

Preferably, each terminal comprises a metal-plated flank and a metal-plated pad.

Advantageously, at least part of a flank comprising a metal plating means that the semiconductor package can be coupled to a PCB by both an underside (i.e. the pad) and a flank of the terminal. This means a greater thickness of solder can be used, which means a wider range of inspection processes can be used to confirm the soldered joint is robust and the semiconductor package is securely coupled to the PCB.

The plurality of terminals may further comprise a third array of terminals, disposed along a third side of the semiconductor package, and a fourth array of terminals, disposed along a fourth side of the semiconductor package, wherein the fourth side opposes the third side.

The first, second, third and fourth sides of the die may define all sides of a four-sided die. Put another way, a respective plurality of terminals may extend from each side of the semiconductor package (or die). This may be referred to as a four-sided configuration (e.g. QFN - quad, flat, no-leads). The no leads may refer to the fact that the terminals are not provided on elongate conductive legs which extend beyond the encapsulant.

A thickness of the flank may be equal to a thickness of the terminals.

Advantageously, more material is available for electrical connection to the PCB. Thickness here is intended to refer to a height of the terminals, which may be described as a minor dimension of the terminal. The thickness of the flank may be equal to a thickness of that terminal. The thicknesses of all flanks may be equal to a minimum thickness of the plurality of terminals. The thickness of the flank may be equal to a minimum thickness (e.g. height) of the die paddle. The thickness of the flank may be equal to a minimum thickness (e.g. height) of the lead frame.

According to a second aspect of the invention there is provided a method of manufacturing a batch of semiconductor packages, comprising:
coupling a plurality of dies to a plurality of die paddles, the plurality of die paddles being provided on a lead frame in an array, wherein each die paddle defines a respective semiconductor package, and coupling the plurality of dies to a plurality of terminals on the plurality of die paddles, the terminals corresponding to each die paddle comprising at least a first array of terminals, disposed along a first side of each semiconductor package, and a second array of terminals, disposed along a second side of the semiconductor package, wherein the second side opposes the first side;
providing a fused encapsulant over the plurality of semiconductor packages, the fused encapsulant at least partly surrounding the array;
removing a first portion of the fused encapsulant, and a first portion of a connecting bar of the lead frame extending between terminals of respective arrays of terminals of each semiconductor package, by a first removal operation, to expose a flank of the terminals whilst the terminals remain electrically connected to one another;
plating at least part of the pads, including at least part of the exposed flank, using a plating process;
removing a second portion of the fused encapsulant, and a second portion of the connecting bar, by a second removal operation, to isolate the terminals within each array of terminals and to define recesses between each isolated terminal of each of the first and second arrays of terminals; and
cutting the fused encapsulant at a plurality of positions to singulate the semiconductor packages from the array.

A batch of semiconductor packages may be referred to as a plurality of semiconductor packages.

The lead frame and/or die paddle(s) may otherwise be described as a plate of conductive material. The die paddle may be manufactured from a copper alloy or entirely from copper. The die paddle may have a variable thickness (e.g. incorporate one or more projecting features).

Each die paddle defining a respective semiconductor package may otherwise be described as each individual die paddle going on to form a separate semiconductor package. The die paddle may consist of a single body, or may comprise a plurality of portions (e.g. a multi-part, or multi-piece, die paddle).

The die may be a single component or may comprise multiple constituent components. The die is preferably coupled to the die paddle using solder. The die being coupled to the die paddle may otherwise be described as the die being attached to the die paddle. The die may be a silicon chip. The plurality of dies may be coupled to a respective plurality of die paddles (e.g. one die per die paddle).

Fused encapsulant is intended to refer to a conjoined encapsulant moulded in a single mould. For example, the fused encapsulant may be moulded over multiple respective semiconductor packages. The encapsulant may be plastic. The encapsulant may otherwise be described as being manufactured from a polymer. The encapsulant is preferably manufactured using an injection moulding process where an at least partially molten material is moulded into the desired encapsulant shape. The plastic may be a thermoplastic (e.g. a thermosetting polymer).

The connecting bars preferably extend directly between adjacent terminals. Put another way, the connecting bars preferably take the most direct path (e.g. a straight-line path) between the terminals.

Singulating the semiconductor package from the array may otherwise be described as separating, or detaching, the semiconductor package from the array. Alternatively, it may be described as severing the semiconductor package from the array.

In embodiments where the dies are directly coupled to terminals, the steps of coupling the dies to the die paddles and coupling the dies to the terminals may be simultaneous (e.g. in the same step). That is to say, in some embodiments, coupling the die to the die paddle may also include coupling the die to the plurality of terminals. In other embodiments, the die may be coupled to the die paddle in a first step. In a subsequent step, the die may be coupled to the terminals, the terminals being a separate subcomponent within the die paddle.

Advantageously, the semiconductor packages can be readily inspected when coupled to a PCB owing to the recesses.

Removing the second portion of the connecting bar may comprise removing the remainder of the connecting bar.

One or more of the first and second removal operations may comprise one or more of a laser cutting, water jetting, sawing or chemical etching process.

Coupling the plurality of dies to the plurality of terminals may comprise using a wirebonding process.

Removing a first portion of the connecting bar may comprise severing a fused connecting bar, the fused connecting bar extending between a second array of terminals of a first semiconductor package, and a first array of terminals of an adjacent second semiconductor package.

The first removal operation may comprise removing material in a plurality of intermittent, elongate regions.

The plurality of die paddles may further comprise a third array of terminals, disposed along a third side of each semiconductor package, and a fourth array of terminals, disposed along a fourth side of each semiconductor package, wherein the fourth side opposes the third side.

According to a third aspect of the invention there is provided a lead frame for manufacturing semiconductor packages, comprising:
an array of die paddles, wherein each die paddle defines a respective semiconductor package;
a plurality of terminals disposed around each die paddle, each plurality of terminals comprising a first array of terminals, disposed along a first side of the die paddle, and a second array of terminals, disposed along a second side of the die paddle, wherein the second side opposes the first side, each of the plurality of terminals comprising a pad with a flank;
wherein the terminals within each first array of terminals are electrically connected to one another by a first connecting bar, the first connecting bar extending directly between the terminals;
wherein the terminals within each second array of terminals are electrically connected to one another by a second connecting bar, the second connecting bar extending directly between the terminals;
wherein adjacent die paddles are electrically connected to one another by one or more of the first and second connecting bars.

A plane parallel to the first and second directions may otherwise be described as a plane through a thickness of the lead frame (e.g. through a minimum dimension of the lead frame). The plane parallel to the first and second directions may be described as a plan parallel to a plan view of the lead frame.

The first and second connecting bars extending directly between respective terminals is intended to mean that the first and second connecting bars extend in a straight manner. At least a portion of a thickness of the connecting bars is adjacent the terminals. The connecting bars may be described as extending through centre points of the terminals of that array. The connecting bars may be described as extending in the shortest distance possible between the terminals.

A thickness of the first and second connecting bars is preferably greater than a corresponding thickness of members which extend between the first and second connecting bars.

Advantageously, connecting bars having the aforementioned structure provide a more robust lead frame. The lead frame is more suited to wirebonding operations. Furthermore, a thickness of the overall lead frame can be reduced (e.g. perpendicular to the thickness of the connecting bars).

Embodiments of the present invention will now be described, by way of example only, with reference to the accompanying drawings in which:
Figures 1 and 2 are perspective views of a semiconductor package according to an embodiment of the invention;
Figure 3 is a plan view of an underside of the semiconductor package of Figure 1;
Figure 4 is a perspective view of the semiconductor package shown in Figures 1 to 3 with an encapsulant shown in a partially-transparent view;
Figure 5 is a perspective views of a semiconductor package according to another embodiment of the invention;
Figure 6 is a plan view of an underside of the semiconductor package of Figure 5;
Figure 7 is a generally plan view of a lead frame according to an embodiment of the invention;
Figure 8 is a plan view of a first die paddle of the lead frame of Figure 7;
Figure 9 is a plan view of an underside of the lead frame of Figure 7;
Figure 10 is a perspective view of the lead frame of Figures 7 and 9 with dies coupled to die paddles;
Figure 11 is a perspective view of the part-assembled array of Figure 10 with a fused encapsulant moulded;
Figure 12 is a perspective view of an underside of the part-assembled array of Figure 11 after a first removal operation occurs;
Figure 13 is a plan view of the underside of the part-assembled array of Figure 12;
Figure 14 is a plan view of the underside of the part-assembled array of Figures 12 and 13 with the fused encapsulant shown in a partially-transparent view;
Figure 15 is a perspective view of the underside of the part-assembled array of Figure 12 after a plating process is carried out;
Figure 16 is a perspective view of the underside of the part-assembled array of Figure 15 after a second removal operation occurs;
Figure 17 is a plan view of the underside of the part-assembled array of Figure 16;
Figure 18 is a plan view of the underside of the part-assembled array of Figures 16 and 17 with the fused encapsulant shown in a partially-transparent view; and
Figure 19 is a perspective view of the undersides of singulated semiconductor packages following singulation of the part-assembled array of Figures 16 to 18.

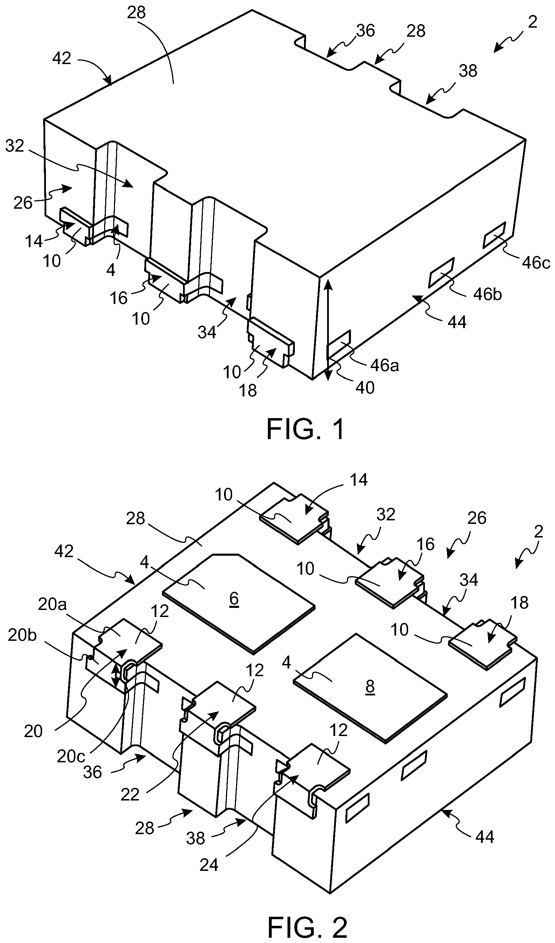

Turning to Figure 1, a perspective view of a semiconductor package 2 according to an embodiment of the invention is provided.

The semiconductor package 2 comprises a die paddle 4, the die paddle 4 only being partly visible in Figure 1 but being more clearly visible in Figure 2 (with constituent first and second portions labelled 6 and 8 respectively). The semiconductor package 2 further comprises a die which is coupled to the die paddle 4 but not visible in Figure 1. The semiconductor package 2 further comprises a plurality of terminals. The terminals 2 may be described as IO (input/output) terminals.

The plurality of terminals comprises first and second arrays of terminals 10, 12 respectively. The first array of terminals 10 comprises first to third terminals 14, 16, 18. The second array of terminals 12, not visible in Figure 1 but shown in Figure 2, comprises a corresponding first to third terminals 20, 22, 24. The first array of terminals 10 is disposed along a first side 26 of the semiconductor package 2 (and the die paddle 4). The second array of terminals 12 is disposed along a second side 28 of the semiconductor package 2 (and die paddle 4). The second side 28 opposes the first side 26.

With continued reference to Figure 2, each of the terminals comprises a pad with a flank. Taking the first terminal 20 of the second array 12 as an example, the terminal 20 comprises a pad 20a and a flank 20b. The pad 20a, in use, may be described as an underside of the terminal 20. The flank 20b is a portion of the terminal 20 which has a thickness and can be described as defining at least part of the height of the terminal 20. The flank 20b may be described as a thickness of the pad 20a. In use, the flank provides a further area by which the terminal can be connected to a PCB. Such flanks may be referred to as a side-wettable flank (SWF). As described in connection with the terminal 20, each of the other terminals also comprises a corresponding pad and flank. A thickness of the flank 20b is labelled 20c for reference. This thickness 20c may be described as in a direction parallel to a height of the semiconductor package 2 (e.g. 40 in Figure 1).

Returning to Figure 1, the semiconductor package 2 further comprises an encapsulant 28, which may be described as a casing. The encapsulant 28 at least partly surrounds the die (the die being contained by the encapsulant 28). The encapsulant 28 may be a polymer.

With continued reference to Figure 1, four recesses 32, 34, 36, 38 are defined as part of the semiconductor package 2. Taking the first and second recesses 32, 34 as examples, the recesses 32, 34 are defined between each of the first and second terminals 14, 16, and the second and third terminals 16, 18 respectively. Although not visible in Figure, with brief reference to Figure 2, the third and fourth recesses 36, 38 are defined between the first and second terminals 20, 22, and the second and third terminals, 22, 24 of the second array 12 respectively. As such, a recess is defined between each terminal of each of the first and second arrays of terminals 10, 12. Advantageously, by incorporation of these recesses, the terminals effectively project from, or are exposed from, the encapsulant 28. As such, it is easier to inspect the soldered joints, between the terminal and a PCB to which the semiconductor package 2 is coupled, using a top down review (e.g. from the orientation generally shown in Figure 1). The inspection may be by way of an Automated Optical Inspection (AOI) of the assembled PCB. The inspection may comprise inspecting a spread of the solder.

Linked to the above advantage, by comparing Figures 1 and 2 it will be appreciated that the pads and the flanks of each of the terminals comprises a metal plating. This is preferably a metal plating. The metal plating facilitates the adhesion of solder to the pads and flanks to aid with the coupling of the semiconductor package 2 to, and electrical conductivity with, a PCB. Incorporation of the flanks, as part of the terminals, also advantageously provides a greater surface area by which solder can be adhered to provide electrical communication with a PCB and corresponding pad. Furthermore, as mentioned above, the flank is more readily inspected by an AOI (which may be necessary in some industries).

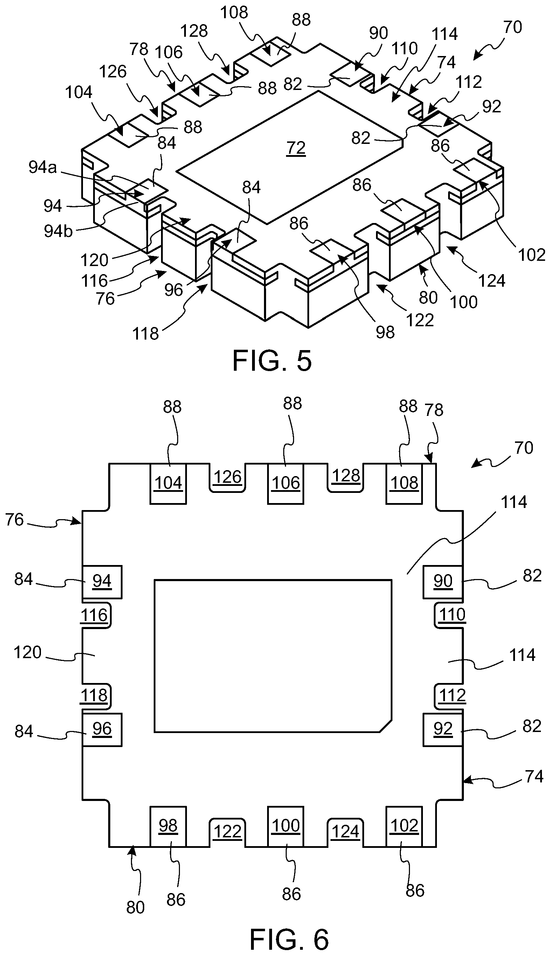

As well as each of the recesses 32, 34, 36, 38 being defined between various terminals of the first and second arrays 10, 12, in the illustrated embodiment each of the recesses extend from a first terminal to a second terminal of an adjacent pair of terminals. Put another way, each of the recesses 32, 34, 36, 38 extends entirely between (i.e. from one to another) adjacent terminals. In other embodiments, such as a four-sided configuration (see Figures 5 and 6) this may not be the case. Furthermore, each of the recesses 32, 34, 36, 38 extends through an entire height 40 of the encapsulant 28 (and so semiconductor package 2). Each of the recesses is also a stepped recess.

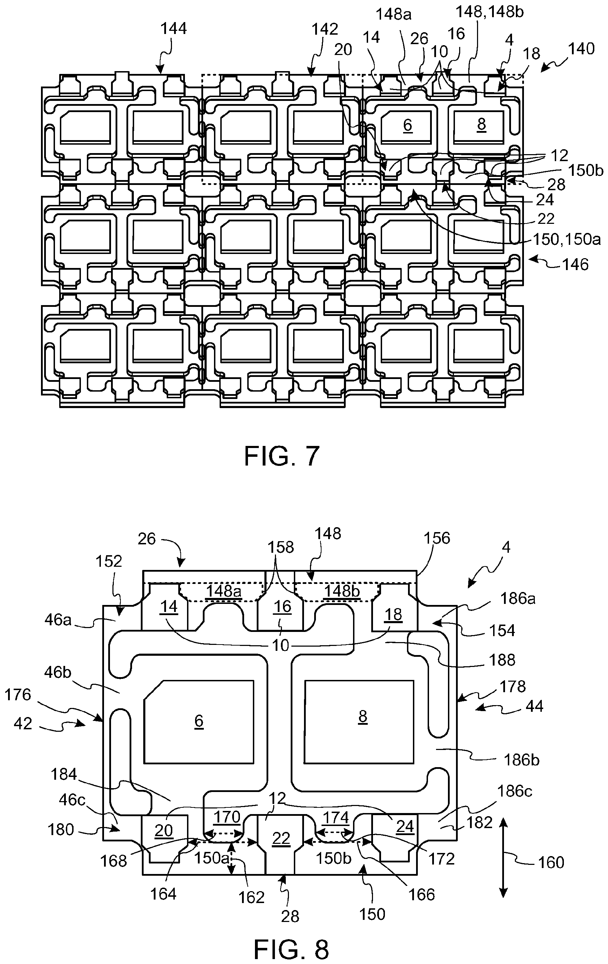

The semiconductor package 2 also has third and fourth sides 42, 44. The semiconductor package 2 is a two-sided configuration, and so third and fourth sides 42, 44 are absent any terminals. However, and again as will be shown and described in connection with Figures 5 and 6, for a four-sided configuration the third and fourth sides may have terminals disposed thereon. Returning to Figure 1, taking the fourth side 44 as an example, although as shown in Figure 1 there are three exposed portions 46a-c of the die paddle 4, these are not terminals per se and are merely artefacts of the die paddle 4 starting as part of a lead frame (see Figures 7 and 8) in the manufacture process. The exposed parts 46a-c are present during the manufacturing process to facilitate an electrical connection between the terminals of adjacent die paddles, but are severed at the point where the individual semiconductor packages 2 are singulated (e.g. separated from the array). This will be described and shown in connection with later figures.

For completeness, Figure 1 shows the semiconductor view generally from a top side. Figure 2 shows the semiconductor package 2 generally from an underside (e.g. as indicated by the presence of the various terminals).

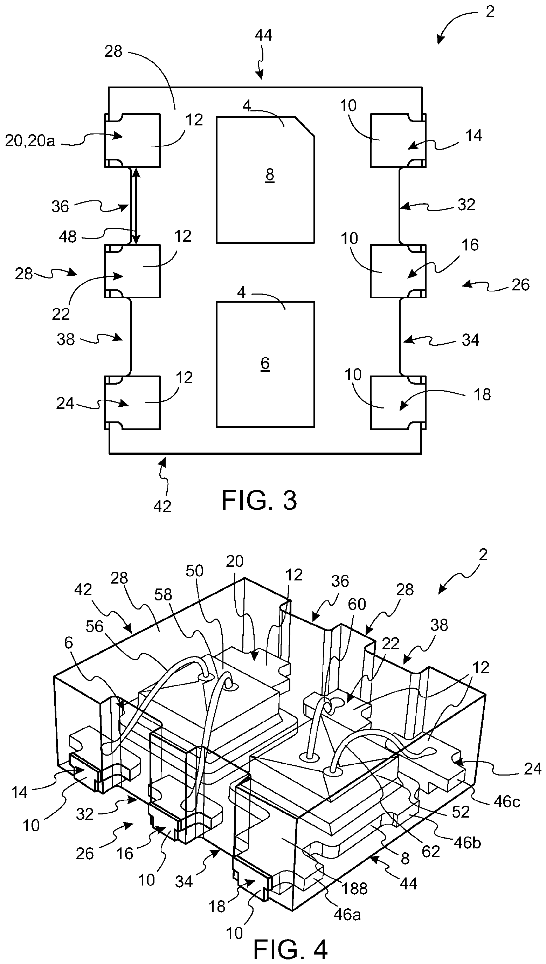

Turning to Figure 3, a plan view an underside of the semiconductor package 2 is provided. The Figure 3 view therefore generally corresponds to that shown in Figure 2, and appropriate features are labelled.

In connection with the recess 36, a schematic marker 48 indicates that an extent of the third recess 36 generally corresponds to a distance between the first and second terminals 20, 22 of the second array 12. Put another way, as well as the third recess 36 being defined between the first and second terminals 20, 22, the third recess 36 also extends from the first terminal 20 to the second terminal 22 (i.e. entirely therebetween).

Turning to Figure 4, a perspective view of the semiconductor package 2 is provided but with the encapsulant 28 shown in a semi-transparent manner. Various internal components of the semiconductor package 2 are thus visible in Figure 4.

Figure 4 shows the first and second portions 6, 8 of the overall die paddle 4. As is partially visible in Figure 4, the first and second portions 6, 8 are not actually electrically connected to one another. However as will be appreciated by brief reference to Figure 8, when the die paddle is initially attached to the lead frame, both of these portions are (initially) electrically connected to one another. However, they are separated in a subsequent process step.

Returning to Figure 4, first and second die portions 50, 52 are visible in Figure 4. The first and second die portions 50, 52, collectively define a die. The first die portion 50 is coupled to the first portion 6 of the die paddle. The second die portion 52 is coupled to the second portion 8 of the die paddle 4. The coupling may be way of bonding, for example a solder layer. Taking the first die portion 50 as an example, two leads 56, 58 couple the first die portion 50 to the first and second terminals 14, 16 of the first array of terminals 10. This coupling provides an electrical connection between the die portion 50 and the terminals 14, 16. In the illustrated example the coupling between the first die portion 50 and the terminals, 14, 16 is by way of wire bonding. However, this is not essential and in other embodiments an alternative connection, such as the use of a rigid connector, could otherwise be employed.

Turning to the second die portion 52, as previously described the second die portion 52 is coupled to the second portion 8 of the die paddle 4. The second die portion 52 is coupled to the second and third terminals 22, 24 of the second array of terminals 12. This coupling provides an electrical connection between the second die portion 52 and the terminals 22, 24. Like for the first die portion 50, the electrical coupling is provided by leads 60, 62 which extend from the second die portion 52 to the second terminal 22 and third terminal 24 respectively. Leads 60, 62 are again formed by a wire bonding process, but other connection methods could otherwise be used.

Figure 4 also shows the third terminal 18 of the first array of terminals 10 rigidly connected to the second portion 8 of the die paddle. This rigid connection is by way of a bridge 188 of the die paddle 4. As such, the third terminal 18 may, in some interpretations, be considered to form part of the second portion 8 of the die paddle 4.

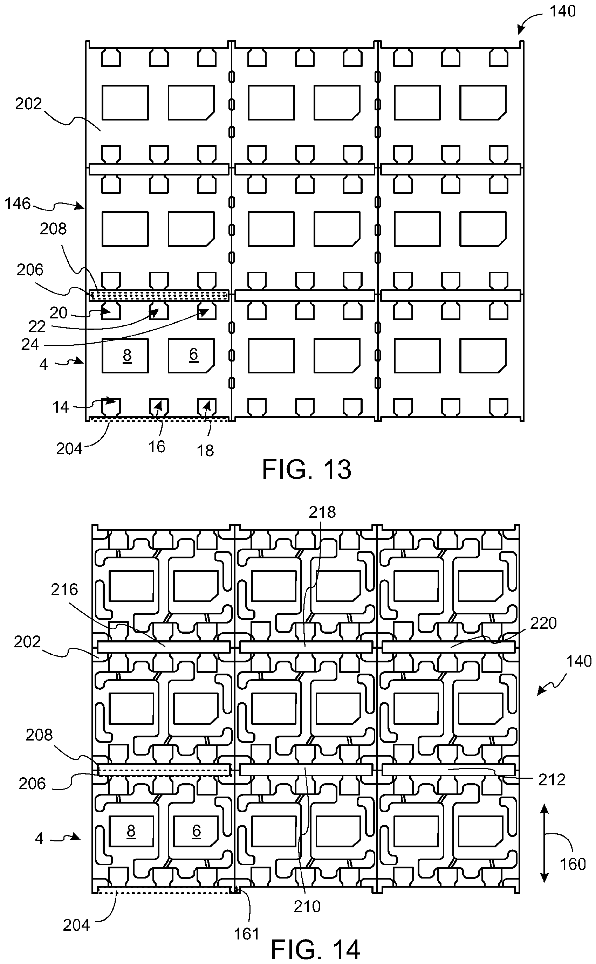

The same is also true for the first terminal 20 of the second array 12 forming part of the first portion 6 of the die paddle 4. This will also be appreciated by brief reference to Figure 8 and 14 (with the bridges being labelled 188, 184 in Figure 8).

Figure 4 also indicates how the exposed portions of the die paddle 46a-c are effectively cut lines defined when the second portion 8 of the die paddle 4 is removed from the lead frame. By comparing Figures 1, 2 and Figure 4, it will be appreciated that many of the components described in connection with Figure 4 are entirely, or partially, obscured/enclosed by encapsulant 28.

Figure 4 also shows how each of the first, second and third 14, 16, 18 terminals of the first array 10 are electrically isolated from one another when the semiconductor package 2 has been singulated. Described another way, a connecting bar, such as that shown in Figure 8 (e.g. labelled 148), which previously extended between the terminals, is removed as part of the manufacturing process. The same also applies for the first to third terminals 20, 22, 24 of the second array 12.

In some embodiments the dies, or die portions, may be directly coupled to terminals. That is to say, there may not be first and second portions of die paddles, as in the illustrated embodiment. Instead, the terminals may constitute a part of the die paddle to which the die, or die portion, is coupled (e.g. bonded).

Turning to Figure 5, a perspective view generally corresponding to an underside (e.g. like that of Figure 2) of a semiconductor package 70 according to another embodiment is provided. The semiconductor package 70 shares many features in common with the semiconductor package 2 already described, and so common features will not be described in detail for brevity. However, as will be apparent by comparing Figure 5 with Figure 2, the semiconductor package 70 relates to a four-sided configuration (e.g. in contrast to the two-sided configuration of the semiconductor package 2). As such, terminals are disposed along each of first to fourth sides 74, 76, 78, 80 of the semiconductor package 70.

Like the previous embodiment, the semiconductor package 70 comprises multiple arrays of terminals. The semiconductor package 70 comprises four arrays of terminals 82, 84, 86, 88. Each of the first to fourth arrays of terminal 82, 84, 86, 88 are disposed along each of the first to fourth sides 74, 76, 78, 80 of the semiconductor package 70 respectively. The first array 82 of terminals comprises first and second terminals 90, 92 respectively. The second array of terminals 84 comprises first and second terminals 94, 96 respectively. The third array of terminals 86 comprises first, second and third terminals 98, 100, 102. The fourth array 88 of terminals comprises first, second and third terminals 104, 106, 108.

Turning to describe recesses between the various terminals, and starting with the first array of terminals 82, first and second recesses 110, 112 are defined between the first and second terminals 90, 92. Unlike the first embodiment, first and second recesses 110, 112 do not extend between the first and second terminals 90, 92 owing to a projection 114 disposed there between. A corresponding arrangement is provided for the second array 84 by way of recesses 116, 118 which again are defined between first and second terminals 94, 96 but do not extend therebetween owing to projection 120. For each of the first and second arrays 82, 84, a plurality of recesses (110, 112, 116, 118) extend between the adjacent pairs of terminals.

Turning to the third and fourth arrays of terminals 86, 88 respectively, beginning with the third array 86: first and second recesses 122, 124 are defined between the first and second terminals 98, 100 and the second and third terminals 100, 102 respectively. As such, one recess is defined between each adjacent pair of terminals. Turning to the fourth array 88, first and second recesses 126, 128 are defined between the first and second terminals 104, 106 and the second and third terminals 106, 108 respectively. As such, and like the third array 86, a recesses is defined between each adjacent pair of terminals, although it does not extend therebetween.

With brief reference to the first terminal 94 of the second array 84, as previously described the terminal 94 comprises a pad 94a and a flank 94b. However, it will be appreciated that the flank 94b extends along the corresponding second side 76 along a greater extent than that of the pad 94a. The same applies for each of the terminals in the illustrated four-sided configuration (although, in other embodiments, this may not be the case). Of note, the projections 114, 120 do not comprise a corresponding pad, hence their reference as projections rather than terminals.

Turning to Figure 6, a plan view of the underside of the semiconductor package 70 is provided.

Turning to Figure 7, a perspective view of a lead frame 140, according to an embodiment in the invention, is provided. Figure 7 is generally provided from an underside of the lead frame 140.

The lead frame 140 is a generally a planar sheet, with various protruding features formed thereon, preferably manufactured from copper or copper alloy. The lead frame 140 may be manufactured by a chemical etching, stamping or other process.

As shown in Figure 7 the lead frame 140 defines an array of die paddles. Each die paddle goes onto define, and form part of, a respective semiconductor package. As shown in Figure 7, a first die paddle is labelled 4, with second, third and fourth die paddles labelled 142, 144, 146 respectively. The boundaries indicating the footprint of the first and second die paddles 4, 142 are schematically indicated on Figure 7 using dashed lines. By comparing Figure 7 with Figure 2 it will be appreciated that the upper array of terminals as shown for the die paddle 4 corresponds to the first array of terminals 10 in Figure 2. Similarly, the lower array of terminals corresponds to the second array of terminals 12. As described in connection with Figure 2, the first array of terminals 10 is disposed along a first side 26 of the die paddle 4, and the array of terminals 12 is disposed along a second side 28 of the die paddle.

Extending between the terminals of each array of terminals (e.g. 10, 12) are respective connecting bars. A first connecting bar 148 comprises first and second parts 148a, 148b. The first connecting bar 148 electrically connects each of the first, second and third terminals 14, 16, 18 forming part of the first array of terminals 10. Of note, the connecting bars (e.g. first connecting bar 148) are limited by the boundary of the die paddle/semiconductor package (e.g. by the dashed line which defines the die paddle 4). The first and second parts 148a, 148b may be described as extents of the first connecting bar 148 which extend directly between adjacent terminals. That is to say, the first and second parts 148a, 148b have the shortest length possible whilst still extending between the adjacent terminals. For example, a U-shaped connecting bar, or part thereof, is not considered to extend directly between adjacent terminals.

In view of the above description of the first connecting bar 148 disposed on the first side 26 of the die paddle 4, on the opposing, second side 28 a corresponding second connecting bar 150 is disposed. The second connecting bar 150 extends between, and electrically couples, the first, second and third terminals 20, 22, 24 of the second array of terminals 12. The second connecting bar 150 comprises first and second parts 150a, 150b. The first part 150a extends between the first and second terminals 20, 22. The second part 150b extends between the second and third terminals 22, 24 respectively.

For the reasons described above, the first and second connecting bars 148, 150 couple, and electrically connect, each of the first to third terminals of each of the first and second arrays 10, 12 respectively. As will be briefly described in connection with Figure 8 below, each of the connecting bars 148, 150 further comprises a tab which extends from an end of the connecting bar to effectively couple the connecting bar to an adjacent connecting bar in a direction along a (longitudinal) extent of the connecting bars. Furthermore, where the die paddle is provided with an array of terminals (e.g. the second array 12) and an adjacent die paddle (e.g. die paddle 146) comprises an adjacent array of terminals, the adjacent connecting bars (e.g. including 150) may be described as defining a fused connecting bar. In the illustrated example, a fused connecting bar extends between the second array 12 of terminals on the first semiconductor package 4 and a (adjacent) first array of terminals of the adjacent fourth semiconductor package 146.

By virtue of the connecting bars, each die paddle is connected to multiple other adjacent die paddles. As such, the entire lead frame 140 is electrically connected. This is desirable for the reason that metal plating pads and flanks of the terminals, which occurs partway through the manufacturing process, can occur whilst the entire lead frame 140 is held at the same potential. This makes the process easier to carry out than if, for example, each of the terminals was already electrically isolated at this stage in the process (in which case each terminal would need to be individually connected to hold them at the same potential).

As will be described in detail in connection with the manufacturing process, the connecting bars go on to be at least partially removed to electrically isolate the terminals from one another and to singulate adjacent die paddles, and so semiconductor packages, from one another.

Turning to Figure 8, a magnified view of the first die paddle 4 in isolation is provided. Of note, at the point in the manufacturing process where the semiconductor packages are singulated from the array, various other components (such as the die, leads etc.) will have been coupled to the die paddle 4. As such, during manufacturing a singulated die paddle (in isolation) will not typically occur. However, Figure 8 is included here to provide more description around the connecting bars.

Firstly, it will be recalled that the first connecting bar 148 comprises first and second parts 148a, 148b. The first connecting bar 148 electrically connects the first, second and third terminals 14, 16, 18 of the first array 10.

Also as previously mentioned in connection with Figure 7, first and second tabs 152, 154, which form part of the first connecting bar 148, are shown in Figure 8. The first and second tabs 152, 154 do not extend between terminals of a respective array but instead extend between end terminals of adjacent, but not fused, arrays of terminals. Put another way, in Figure 7, tabs of the first connecting bar 148 couple the first terminal 14 to an adjacent terminal of the second die paddle 142 but these terminals are not fused, or directly opposed, in the same manner as, for example, the terminal 20 of the second array 12 and the adjacent terminal of the fourth die paddle 146. The tabs may otherwise be described as a framework.

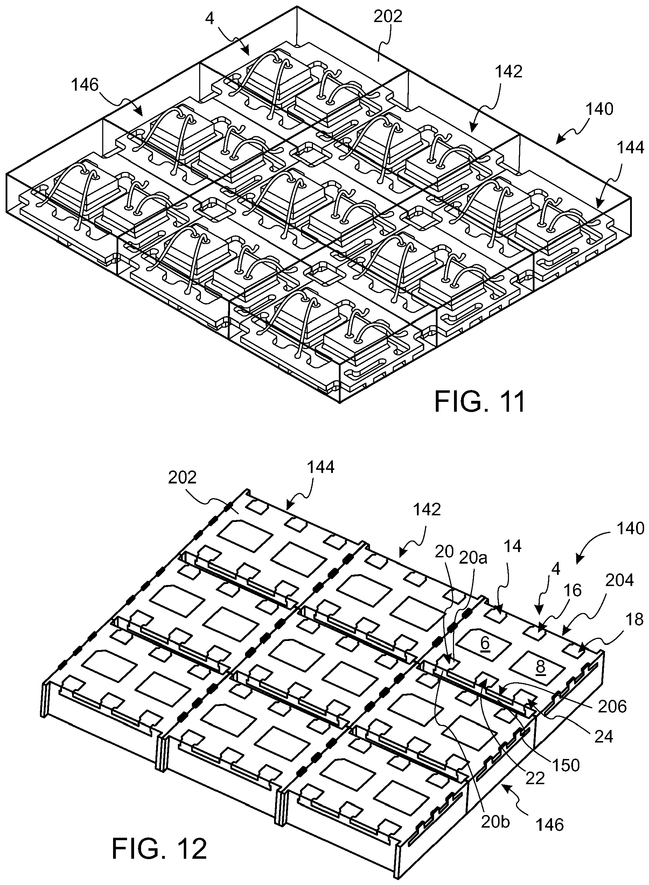

Returning to Figure 8, also schematically indicated for reference are the various portions of the connecting bar 148, as an example, which would be removed during the manufacturing process. Labelled 156 is a first portion of the connecting bar 148 which is removed during a first removal operation (e.g. see Figures 12 to 14). As will be appreciate by comparing Figure 8 with Figure 7, for arrays of terminals which have an adjacent, opposing array of terminals (e.g. such that the respective connecting bars define a fused connecting bar) removal of the portion 156 severs the fused connecting bar. Removal of the first portion 156 also exposes flanks of the connectors 14, 16, 18 (for metal plating).

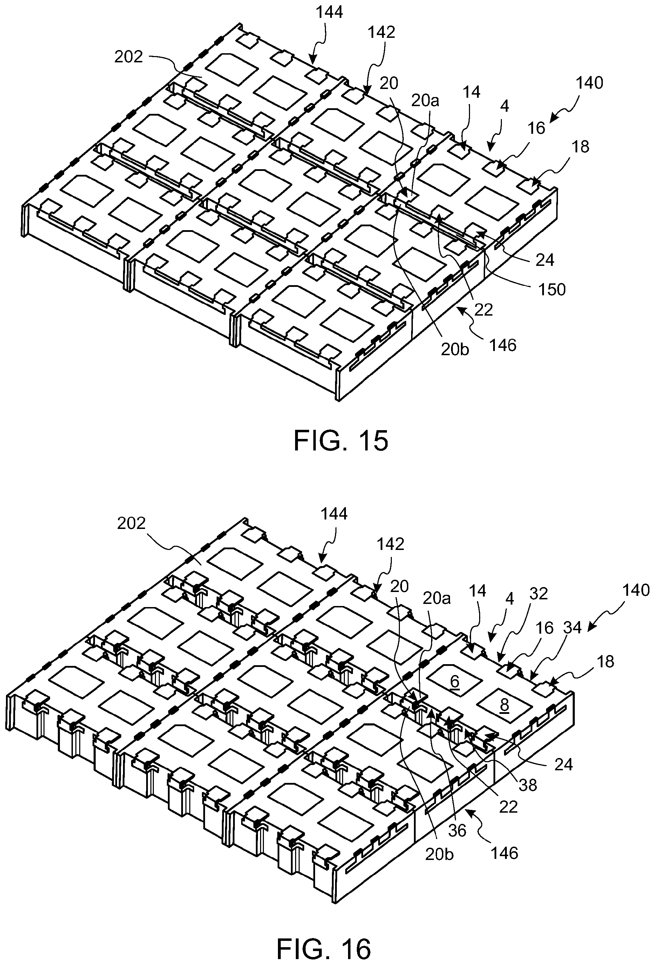

In a subsequent step of the process, as shown in Figures 16 to 18, a second portion 158 of the connecting bar is removed by a second removal operation. Removal of the second portion 158 (labelled in Figure 8) isolates the terminals 14, 16, 18 within each array of terminals (e.g. 10) and also defines the recesses between each isolated terminal (e.g. see recesses 32, 34 shown in Figure 2). In some embodiments, the second removal operation may remove all of the connecting bar. However, in other embodiments some of the connecting bar may remain, although not electrically coupling the adjacent terminals.

A further advantage of the design of lead frame 140 in Figure 7 and the die paddle 4 in Figure 8 is that the thickened connecting bars (e.g. 148, 150) reinforce the lead frame structure so that the lead frame 140, and constituent die paddles, are more stable during the manufacture process. For example, during the step of wire bonding there is a lower risk of damage occurring.

In order to obtain the advantage, a minimum thickness of connecting bar, between the connected terminals, is preferably 175 microns in a plane parallel to the lead frame 140. This may otherwise be described as having a minimum thickness of 175 microns in a direction schematically indicated 160 in Figure 8. An extent of a minimum thickness is labelled 162, again the minimum thickness being defined between connected terminals (20, 22 in this instance). That said, in other embodiments the connecting bars may have a different thickness (e.g. less than 175 microns) depending upon a distance between adjacent terminals (e.g. to isolate the terminals).

The dimension 162 may be described as determining the recess depth after the second removal operation occurs. Dimensions 164, 166 may be described as determining a recess width (e.g. between each isolated terminal). A minimum recess depth, and a minimum recess width, is determined by a minimum distance needed to isolate the terminals from one another after the second removal operation occurs.

With continued reference to Figure 8, the thickness 162 of the connecting bar 150 as indicated along a portion of the connecting bar which extends between first and second terminals 20, 22 of the second array 12 is labelled 164. As will be appreciated, part of the connecting bar 150 does extend further beyond the extent 162 in a direction moving towards the second side 28 (e.g. between the terminal 20 and second side 28). However, for ease of reference, the extent 164 is labelled, in connection with the first part 158 of the second connecting bar 150 only, to provide suggested dimensions.

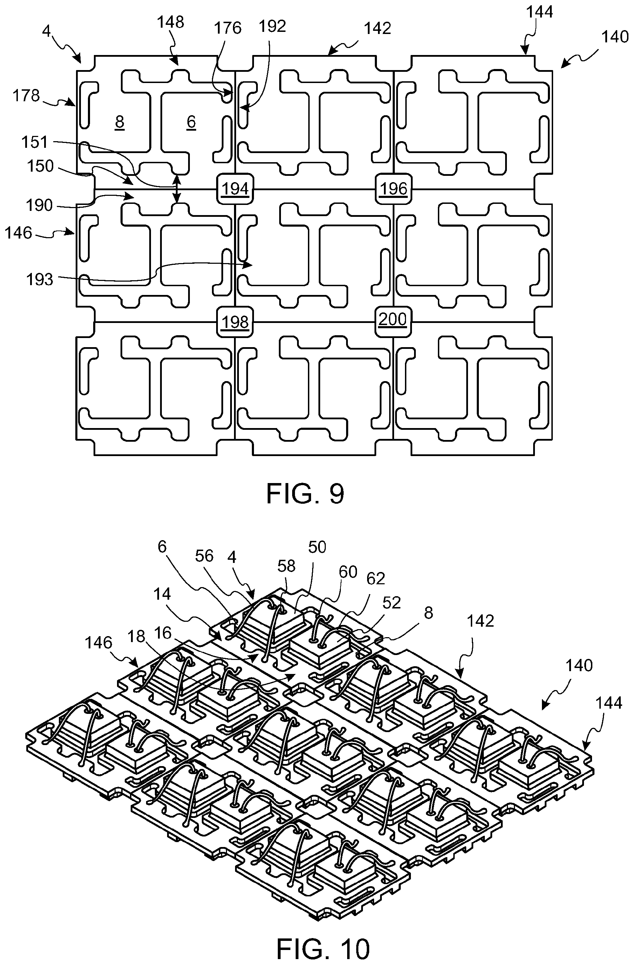

The inventors have advantageously found that the connecting bar 150 having a thickness (e.g. 162) of at least 175 microns (in the direction 160) between connected terminals (e.g. between terminals 20, 22, as indicated at 164) is particularly advantageous for providing at lead frame 140 which has improved rigidity and robustness. For the avoidance of doubt, the corresponding extent of a second part 150b of the second connecting bar 150 is labelled 166. In accordance with the previous discussion, advantageously the thickness 162 is at least 175 microns across the regions 164, 166 (for the second connecting bar 150), and it will be appreciated that, given Figure 7, this repeats across all of the die paddles in the lead frame array 140. Returning to Figure 8, the extent 164 also spans at least an extent 168 of a recess 170 which is defined between the first portion 6 of the die paddle 4 and the second connecting bar 150. Similarly, the second extent 166 spans at least an extent of a recess 174 which extends between the second portion 8 for the die paddle 4 and the second connecting bar 150. Despite the above, in other embodiments the connecting bars may have a thickness of less than 175 microns. With brief reference to Figure 9, a fused connecting bar, i.e. a combination of two adjacent connecting bars 150, 190, preferably has a minimum thickness 151 of 350 microns.

Although not labelled in Figure 8, it will be appreciated that corresponding recesses, and extents, are present between the first and second portions 6, 8 and the first and second parts 148a, 148b of the first connecting bar 148. For example, the thickness of each of the first and second parts of the connecting bars 148a, 148b between the terminals is at least 175 microns, and this extent covers at least the extent along which recesses, between the first and second die portions 6, 8 and the first connecting bar 150, extend.

Extending between the first and second connecting bars 148, 150 are first and second members 176, 178. The first member 176 generally extends from the first connecting bar 148 at an end proximate the first terminal 14 to the second connecting bar 115 at an end proximate the first terminal 20. Described another way, the first member 176 extends between first tabs 152, 180 of the first and second connecting bars 148, 150. Similarly, a second member 178 extends between the second tabs 154, 182 of the first and second connecting bars 148, 150 respectively. The first member 178 defines a first side 42 of the die paddle 4. The second member 178 defines a second side 44 of the die paddle 4.

With brief reference to Figure 1, it will be recalled that first to third exposed portions of the die paddle 46a-c remain after the semiconductor package 2 has been manufactured and singulated from the array. Returning to Figure 8, the same first to third exposed portions 46a-c are indicated with respect to the first tab 152, first member 178 and the first tab 180 respectively. Put another way, when the semiconductor package has been assembled and is singulated, part of the tabs 152, the first side member 178, and the first tab 180 is removed, as part of the singulation process, to leave the first to third exposed portions exposed 46a-c. It will also be appreciated that the second exposed portion 46b forms part of a bridge between the side member 178 and the first portion 6 of the die paddle 4 by which the first portion 6 is supported. For completeness, a second bridge, generally labelled 184, extends between the first portion 6 and the second connecting bar 150 at first terminal 20. A corresponding, rotated, arrangement is provided for the second portion 8 of the die paddle 4. First, second and third exposed portions 186a-c will go on to be exposed on the fourth side 44 of the die paddle 4 when the semiconductor package has been singulated. First and third portions 186a, 186c are defined in second tabs 154, 182, and the second exposed portion 186b is defined in a bridge which extends between the second portion 8 and the second member 178. A further bridge which extends between the terminal 18 and the first portion 8 is labelled 188.

Turning to Figure 9, a view of a top side of the lead frame 140 is provided First to fourth die paddles 4, 142, 144, 146 are again labelled, which make up the lead frame 140. As will be appreciated from Figure 7, projecting blocks which define parts of the first and second portions of the die paddles (e.g. 6, 8 of Figure 7) and the terminals (e.g. first and second arrays 10, 12 of Figure 7) are not visible in Figure 9 because these features project from an effective top side of the die paddle/lead frame generally.

Owing to the first die paddle 4 in the array being defined at an upper left hand side of the lead frame 140 as shown in Figure 9, it will be appreciated that above (e.g. adjacent the first connecting bar 148) and to the left hand side (e.g. adjacent the second member 178) there is no adjacent die paddle for the first die paddle 4. However, there are two adjacent die paddles on the lower and right hand sides (e.g. adjacent the second connecting bar 150 and the first member 176 respectively). These are the fourth and second die paddles 146, 142 respectively.

Beginning with the fourth die paddle 146, as previously mentioned the fourth die paddle 146 is adjacent the first die paddle 4 and adjacent the second connecting bar 150. The fourth die paddle 146 is identical in geometry to the first die paddle 4. As such, although not described in detail here, the fourth die paddle 146 comprises a first connecting bar 190. Given that the second connecting bar 150 of the first die paddle 4 and the first connecting bar 190 of the fourth die paddle 146 are connected as shown in Figure 9, the combination may be described as a fused connecting bar. Put another way, the combination may be described as a fused pair of connecting bars. As will be described in connection with Figures 12 to 14, in a first removal operation of the manufacturing process a first portion of fused encapsulant, and a first portion of the connecting bars 150, 190 (among other connecting bars in the array) is removed. This exposes a flank of the corresponding terminals. It severs the fused connecting bar.

Turning to describe the second die paddle 142, as previously described the second die paddle 142 is adjacent the first die paddle 4 about the first member 176. The second die paddle 142 comprises a corresponding second member 192. Like the connecting bars 150, 190, the second and first members 176, 192 of the first and second die paddles 4, and 142 respectively are joined as shown in Figure 9. As will be described in connection with later figures, in a singulation step of the process, to separate the semiconductor packages from the array, the first and second members 176, 192 respectively (amongst other die paddles on the array) are removed.

Also shown in Figure 9 are cavities defined between groups of four die paddles. The cavities are labelled 194, 196, 198, 200. Taking the cavity 194 as an example, the cavity is defined between the first die paddle 144, second die paddle 142, fourth die paddle 146 and a fifth die paddle 193. Advantageously, incorporation of the cavities reduces the amount of material required to manufacture the lead frame 140 without negatively impacting the robustness in these regions.

Save for the cavities 194, 196, 198, 200 a solid perimeter of material extends around each of the die paddles forming part of the array 140. This solid perimeter is defined by, taking the first die paddle 4 as an example, the first and second connecting bars 148, 150 and the first and second members 176, 178.

Turning to Figure 10, a perspective view of a subsequent step of the manufacture process is provided. Figure 10 corresponds to a step in a method of manufacturing a batch of semiconductor packages in which a plurality of dies are coupled to a plurality of die paddles, each die paddle defining a respective semiconductor package.

Taking the first die paddle 4 as an example, Figure 10 shows a step of the manufacturing process in which the first and second die portions 50, 52 are coupled to the first and second portions 6, 8 of the die paddle 4 respectively. As previously described, the first and second portions 50, 52 of the die can be considered to make up the die itself. In other embodiments, the die may consist of a single piece. Similarly, the die paddle may only comprise a single portion, unlike the first and second portions 6, 8 in this embodiment.

The die portions 50, 52 are attached to respective portions 6, 8 of the die paddle 4 by a bonding process, such as via a solder layer. Other processes may otherwise be employed. Following attachment of the die portions 50, 52, the die portions 50, 52 are coupled to respective terminals. This coupling may otherwise be described as an electrical connection. Taking the first die portion 50 as an example, the first die portion 50 is coupled to the first terminal 14 by a wire 56, and to the second terminal 16 by a wire 58 (the terminals 14, 16 forming part of the first array of terminals). The electrical connections between the first die portion 50 and the terminals 14, 16 are thus made via a wire bonding process. However, in other embodiments a rigid connector could otherwise be used to couple the die portion to the terminals. A corresponding arrangement is provided for the second die portion 52, but that will not be described here for brevity. Given that the first and second die portions 50, 52 are described as a collective die, the overall die (e.g. the die portions 50 and 52) can be considered to be coupled to terminals on each of the first and second arrays of terminals (e.g. at either side of die paddle 4). This is despite the fact that, taking the first die portion 50 as an example, the first die portion 50 is only electrically connected to the terminals forming part of the first array.

Although corresponding description will not be provided for each of the other various die paddles (e.g. second to fourth die paddles 142, 144, 146) the above description is equally applicable to each of these die paddles, and indeed all of the other die paddles forming part of the array (a 3 x 3 array in the illustrated embodiment). For the avoidance of doubt, the dies are coupled to the top side of the lead frame 114 as shown in Figure 9. An underside of the lead frame 140 array is visible in Figure 10, showing some of the blocks which define the terminals.

As has been described previously, in some embodiments the die, or die portions, may be directly coupled to the terminals. That is to say, the terminals may constitute a portion of the die paddle to which the die, or die portions, is coupled. In such embodiments, that coupling of the die, or die portions, to the terminals may constitute both a die paddle coupling, and a terminal connection, step. Put another way, coupling the die, or die portions, to the terminals may both: i) couple the die, or die portions, to the die paddle; and ii) attach (e.g. electrically couple) the die, or die portions, to the terminals.

Turning to Figure 11, a perspective view of the part-assembled batch of semiconductor packages is shown in a subsequent step of the manufacture process. Relative to Figure 10, in Figure 11 a fused encapsulant 202 is provided over the plurality of the part-assembled semiconductor packages. The fused encapsulant 202 partly surrounds the array 140.

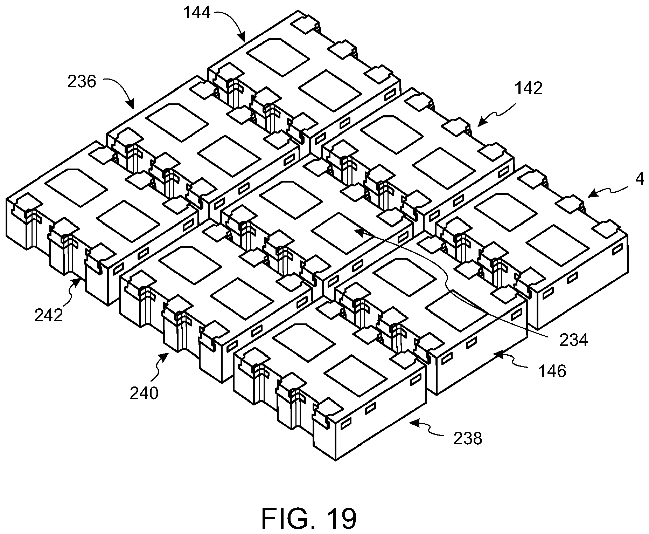

The fused encapsulant 202 is so called because, as will be appreciated by comparing Figure 11 with Figure 19, in a singulation step of the manufacturing process a portion of the fused encapsulant is 202 is removed, along with a portion of the lead frame array 140, to singulate the semiconductor packages. In doing so, an encapsulant is defined (e.g. 28 shown in Figure 1) for each individual semiconductor package. As such, fused encapsulant is used here to refer to a solid block of encapsulant, which will subsequently be divided into separate constituent encapsulants. In short, in Figure 11 a block of encapsulant, e.g. a polymer, is moulded, such as using an injection moulding process, over and around the part-assembled array. The fused encapsulant 202 is shown in a part transparent view in Figure 11 because, were it not for the part transparent view, the majority of the components forming part of the part-assembled array would otherwise be obscured.

Turning to Figure 12, a perspective view of the part-assembled array of semiconductor packages is provided at a subsequent manufactured step. Compared to Figure 11, where the fused encapsulant 202 is provided as a solid block, in Figure 12 a first portion of the fused encapsulant 202, and a first portion of the connecting bars, is removed by a first removal operation. This operation exposes the flanks of the terminals whilst the terminals still remained electrically connected to one another, to facilitate a plating process.

Also of note, the orientation of the array in Figure 12 is flipped relative to that shown in Figure 11. Put another way, whilst Figure 11 generally shows a top side of the array 140, Figure 12 generally shows an underside (e.g. terminals are visible). The orientation of the array 140 shown in Figure 12 therefore corresponds to the orientation shown in Figure 7.

With reference to Figure 12, as previously described, Figure 12 shows the part-assembled array after a first portion of the fused encapsulant 202, and a first portion of a connecting bar, has been removed. Taking the first die paddle/semiconductor package 4 as an example, first portions of the fused encapsulant 202 and connecting bars are generally labelled 204, 206 respectively. This is also shown, and will be described in connection with, Figures 13 and 14.

Briefly returning to Figure 12, removal of the first portions 204, 206 of the fused encapsulant 202 and the connecting bars (first connecting bar not visible in Figure 12, but the second connecting bar being labelled 150) exposes flanks of the various terminals whilst still leaving each of the terminals electrically connected to one another. Taking the first to third terminals 20, 22, 24 as an example, it will be recalled that these terminals form part of the second array of terminals. Even after the first portion 206 has been removed, the first to third terminals 20, 22, 24 are still electrically connected to one another by the second connecting bar 150. However, equally, by comparing Figure 12 with Figures 9, 10 or 11, for example, it will be appreciated that part of the connecting bar 150 has also been removed. The first portion removed from the connecting bar, albeit shown in connection with the first connecting bar 148, is labelled 156 in Figure 8. The first removal operation may therefore be described as comprising removing material in a plurality in intermittent, elongate regions. For example, in a generally dashed manner.

Briefly, it will be recalled that each of the terminals defines a pad and a flank. Taking the first terminal 20 as an example, the pad is labelled 20a and the flank 20b. The flank 20b defines a thickness of the terminal 20, and it is the flank 20b which is exposed by the first removal operation which has been carried out in Figure 12. In Figure 7 a portion of the second connecting bar 150 extends beyond the flank (e.g. towards the fourth die paddle 146). The flank of terminal 20a would therefore not be exposed, after the fused encapsulant 202 is moulded, in the step shown in Figure 11 (if not for the subsequent first removal operation).

Of note, and after the first removal operation has occurred, the fused encapsulant 202 still extends between all of the die paddles/semiconductor packages which form part of the array 140 because the removed first portions are intermittent in nature. Put another way, the array 140 can still be manipulated as a single, coupled assembly. The material removal operation may occur by way of one or more laser cutting, water jetting, sawing or chemical etching process. Given the combination of encapsulant material (e.g. polymer) and at least part of the lead frame 140 being removed, these are desirable removable processes for the mixture of materials present in the part-assembled array. Laser cutting is particularly advantageously due to a reduced risk of delamination of the encapsulant.

Of note, whilst the removal of the first portions of material 204, 206 has only been described in connection with the first die paddle 4, from Figure 12 it will be appreciated that corresponding first portions of material are removed from effective first and second opposing sides, along which terminals are disposed, of each of the die paddles/semiconductor packages which form part of the array 140.

Turning to Figure 13, a plan view of the underside of the part-assembled array shown in Figure 12 is provided. Of note, the orientation has been rotated relative to that shown in Figure 12 so that the first die paddle 4 corresponds to the lower left hand corner in Figure 13.

Schematically indicated on Figure 13 are the first portions 204, 206 of fused encapsulant and connecting bar, associated with the first die paddle 4, removed in the first removal operation. Removal of these first portions 204, 206 therefore leaves recesses adjacent the first and second arrays of terminals (the first array comprising terminals 14, 16, 18, and the second array comprising terminals 20, 22, 24). For ease of understanding, a further first portion 208 is also schematically indicated, that first portion 208 being associated with the fourth die paddle/semiconductor package 146. It will therefore be appreciated that the combination of the first portions 206, 208 defines a single cavity, and that removal of the first portions 206, 208 occur in a single removal step.

Turning briefly to describe Figure 14, the part-assembled array shown in Figure 13 is again shown but with the fused encapsulant 202 shown in a part-transparent manner. The first portions 204, 206, 208 of material removed in the first removal step are also again annotated but using a different marker for ease of visibility. As shown in Figure 14, and although not labelled, flanks and pads of every terminal are exposed. This is in readiness for a plating process in which a metal layer is provided to improve the solderability of these features. For the avoidance of doubt, in Figure 14 cavities 210, 212, 214, 216 and 218 are also defined in the first material removal step. Cavities which extend around the external die paddles in the array (e.g. that defined by first portion 204 in connection with die paddle 4) are not labelled. From Figure 14 it will be appreciated that the first removal operation may comprise a sequence of removal steps. For example, material may be removed from regions adjacent the first die paddle 4 first, then the second die paddle etc.

An extent of material removed by the first removal operation (i.e. the first portion 204, among others), in the direction 160 (e.g. in a plane parallel to the first and second directions) is labelled 161. The dimension 161 is preferably around 75 microns.

Turning to Figure 15, a perspective view of the part-assembled array at a manufacture step subsequent to that shown in Figures 12 to 14 is provided. In Figure 14, a plating process has been carried out. The plating process may be, for example, a metal plating process such as tin plating. A chemical cleaning step also preferably occurs in the same step.

By comparing Figure 12 with Figure 15 it will be appreciated that exposed portions of the die paddle (e.g. the terminals, first and second portions 6, 8, connecting bars) have been plated. The plating process applies a metallic layer to these portions of the lead frame which greatly improves the adhesion of solder to these features. Of note, the exposed part of the connecting bars (e.g. second connecting bar 150 for the first die paddle 4, with a corresponding first connecting bar not visible) is also plated as part of the process. It will be recalled that, at the point of the plating process occurring, all of the die paddles forming part of the array 140 are still electrically connected to one another. That is to say, all of the terminals are also electrically connected to one another. The entire array 140 can therefore be readily held at the same potential to facilitate the plating process. Described another way, it is not necessary to electrically connect every individual exposed portion of the lead frame 140 in order to separately plate the features. Instead, the overall part-assembled array of semiconductor packages can uniformly be provided at the necessary potential, and then the entire conjoined part-assembled batch be plated at the same time. It will be appreciated that any exposed edges/features (e.g. parts of the first and second members 176, 178 shown in Figure 8) are also plated as part of the plating process.

Turning to Figure 16, the part-assembled array of semiconductor packages 140 is shown in a subsequent manufacture step to that shown in Figure 15.

As will be appreciated by comparing Figures 15 and 16, in Figure 16 a second portion of the fused encapsulant, and a second portion of the connecting bars, has been removed by a second removal operation. This removal step isolates the terminals within each array of terminals and also defines recesses between each isolated terminal of each of the arrays of terminals. With reference to the first die paddle/semiconductor package 4, specifically the first to third terminals 20, 22, 24, by comparing Figures 15 and 16 it will be appreciated that the exposed portion of the (second) connecting bar 150 shown in Figure 15 has been removed in Figure 16. As such, where that exposed portion of connecting bar 150 was the only direct electrical coupling between the adjacent terminals, each of the terminals 20, 22, 24 forming part of the second array of terminals is electrically isolated from one another in Figure 16.

Although not labelled in connection with Figure 16, the second portions of material which are removed correspond to the second portions labelled 158 in Figure 8 (although Figure 8 only shows the second portions in connection with the second connecting bar 150). As such, given that the first portion 156 was removed in the previous step, the net geometries 156, 158 have now effectively been removed from the die paddle 4 (and, indeed, the rest of the semiconductor package [e.g. also including fused encapsulant in these regions]). Similarly, whilst only described in connection with the first die paddle 4, this description applies equally to all of the other die paddles/part-assembled semiconductor packages which form part of the array 140. Of note, despite the second portion(s) being removed in the second removal operation step, the fused encapsulant 208 still extends between all of the semiconductor packages such that they also remain coupled to one another as part of the array 140.

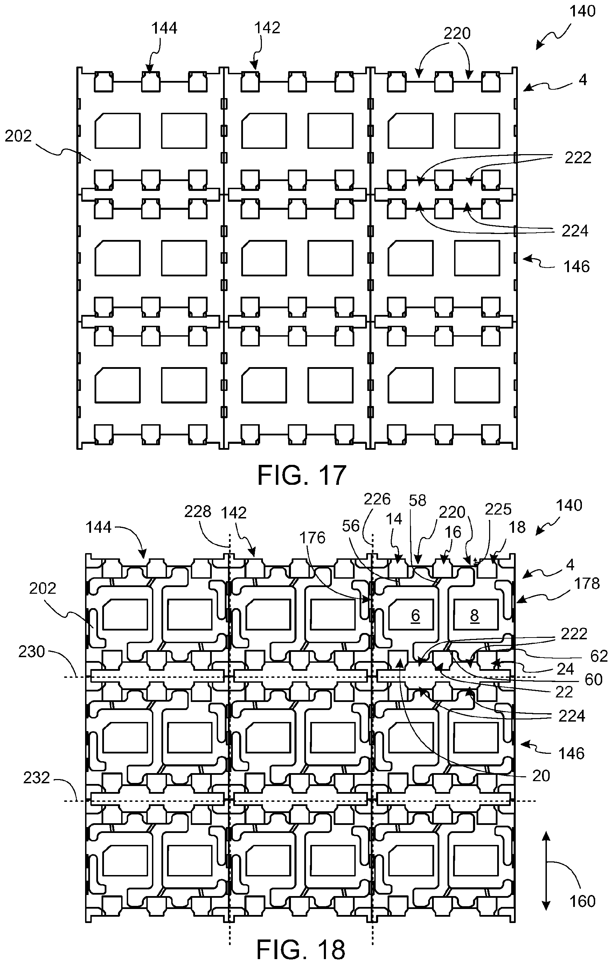

Turning to Figure 17, a plan view of the underside of the part-assembled array of semiconductor packages shown in Figure 16 is provided. Generally labelled in Figure 17 are second portions 220, 222, adjacent first and second arrays of terminals, respectively, of the first semiconductor package 4. A corresponding second portion is labelled 224, corresponding to the fourth semiconductor package 146, adjacent a first set of terminals. Although not labelled in Figure 17 for ease of reference, it will be appreciated that the removal of the second portions 220, 222 defines the first to fourth recesses 32, 34, 36, 38 (e.g. as shown in Figures 1 and 2). A cavity defined between adjacent semiconductor packages can therefore be considered to have increased in size in this step (e.g. cavities 210, 212 shown in Figure 14 have increased by the footprint of recesses 32, 34 etc. shown in Figures 1 and 2).

Turning to Figure 18, a plan view of the underside of the part-assembled array 140 corresponding to that shown in Figure 17 is again provided. However, in Figure 18 the fused encapsulant 202 is shown in a partially transparent view.

Figure 18 is included to show the electrical connections, or lack thereof, between various terminals. With reference to the first semiconductor package 4, the first and second terminals 14, 16 are now electrically isolated from one another. For completeness, it is noted that wires 56, 58 extend between the first and second terminals 14, 16 to the corresponding die portion and so first portion 6 of the die paddle 4. However, electrical isolation here is intended to refer to a lack of a direct electrical connection between the terminals by way of the connecting bar. Similarly, the first and second terminals 16, 18 are electrically isolated from one another.

Turning to the second array of terminals 20, 22, 24, the first and second terminals 20, 22 are electrically isolated from one another. The second and third terminals 22, 24 are also electrically isolated from one another, owing to a lack of a connecting bar. That said, it is again noted that wires 60, 62 connect the terminals to the die paddle portion 8 via the die portion 8. Also of note, owing to the lack of electrical connection between the second and third terminals 16, 18 of the first array, and the first and second terminals 20, 22 of the second array, each of the first and second portions of the die paddle 6, 8 are, at this point, electrically isolated with respect to one another. Advantageously, this means the separate die portions can effectively provide multiple semiconductor devices in a single package.

The first terminals 14, 20 of the first and second arrays respectively are still electrically connected to one another by virtue of the first member 176. Similarly, the third terminal 18 of the first array and the third terminal 24 of the second array are still electrically connected to one another by virtue of the second member 178. As will be appreciated from Figure 19, in a subsequent step of manufacture the first and second members are removed to electrically isolate these terminals from one another.

Although not described in connection with all of the other die paddles and semiconductor packages forming part of the array, the above description is equally applicable to all of the other die paddles/semiconductor packages in the array 140. As shown in Figure 18, in a subsequent singulation step, where the semiconductor packages are separated from the array 140, the fused encapsulant 202, and array more generally, is cut at a plurality of positions as labelled 226, 228, 230, 232. These cut positions separate the semiconductor packages from the array, and may be described as removing a third portion of material (e.g. of die paddles and fused encapsulant) in a third removal operation. It is in this step that the members 176, 178 (among others) are removed, along with remaining fused encapsulant coupling the adjacent semiconductor packages that were previously coupled by fused connecting bars. Cutting the semiconductor packages from the array shown in Figure 18 results in the singulated (i.e. 'finished') semiconductor packages shown in Figure 19.

The singulation step corresponding to cut lines 226, 228, 230, 232 may be carried out by the same cutting methods described in connection with the first and second portions. That is to say, one or more of a laser cutting, water jetting, sawing or chemical etching process may be used. When the singulation step is carried out, and with reference to the first package: as well as the first and second members 176, 178 being removed, the tabs which previously electrically connected the adjacent connecting bars, even at the stage shown in Figure 18 (between the first and second semiconductor packages 142 - see 152, 180 in Figure 8), are also cut. As such, and as is to be expected, the singulation step cuts through the fused encapsulant 220 and a portion of the die paddles to separate, and electrically isolate, the different semiconductor packages from each other.

For completeness, a thickness, or extent, of material removed in the second removal operation (e.g. to form the recesses) in the direction 160 is labelled 225. Thickness 225 is preferably around 100 microns. This may otherwise be described as removal of material in a plane parallel to the first and second directions.

Turning briefly to Figure 19, a perspective view of the singulated semiconductor packages, following on from the singulation step schematically indicated in Figure 18, is provided. For ease of reference, the first to fourth semiconductor packages retain their reference numerals for 4, 142, 144, 146. However, numerals are added for the fifth 234, sixth 236, seventh 238, eighth 240, and ninth 22 semiconductor packages. It will be appreciated that whilst nine semiconductor packages, in a three by three array, have been described, any different number of semiconductor packages could be assembled as a batch using this process.

Furthermore, although throughout the illustrated embodiments show two sided configuration semiconductor packages (e.g. which have two arrays of three terminals), in other embodiments a different number of terminals may otherwise be used. Similarly, whilst the process has been described in detail for a two sided configuration, a four sided configuration, like that shown in Figures 5 and 6, could equally be manufactured using the process. With brief reference to Figure 8, for a four sided configuration die paddle, the members 176, 178 are more akin to the geometry of the die paddle 4 at the first and second sides 26, 28. Put another way, an array of terminals, and associated connecting bar, are provided in place of the comparatively thin first and second members 176, 178. Modifications to the process would include, as shown at Figure 12 onwards, the first portion of fused encapsulant and connecting bar being removed also including the removal of material in the generally vertical direction shown in Figure 12 (e.g. between the first and second semiconductor packages 4, 142, between the second and third semiconductor packages 142, 144 etc.). However, the semiconductor packages would remain electrically connected to one another, and a fused encapsulant coupling them, in similar manner to that shown between the first and second semiconductor packages 4, 146.

The connecting bars described herein may be described as being part of arrays of terminal leads. The connecting bars may be thicker (e.g. deeper) than the terminals.

Advantageously, the invention described herein can be applied to any package with three or more terminals on each (occupied) side. The invention can be applied to any leadless package (e.g. a package where the terminals do not form part of elongate leads that project from the encapsulant). Advantageously, the invention can be used in conjunction with terminals having a fine pitch (e.g. separation therebetween) of around 0.3 mm.

## Claims

1. A semiconductor package for a printed circuit board, PCB, comprising:
a die paddle;
a die coupled to the die paddle;
a plurality of terminals electrically connected to the die, the plurality of terminals comprising a first array of terminals, disposed along a first side of the semiconductor package, and a second array of terminals, disposed along a second side of the semiconductor package, wherein the second side opposes the first side, each of the plurality of terminals comprising a pad with a flank; and
an encapsulant which at least partly surrounds the die; wherein
a recess is defined between each terminal of each of the first and second arrays of terminals.

2. The semiconductor package according to claim 1, wherein each pad and flank is exposed through the encapsulant.

3. The semiconductor package according to claims 1 or 2, wherein each recess is a stepped recess.

4. The semiconductor package according to any preceding claim, wherein each recess extends from a first terminal of the adjacent pair of terminals to a second terminal of the adjacent pair of terminals.

5. The semiconductor package according to any preceding claim, wherein one or more of the terminals comprises a metal plating, the metal plating extending at least partway across the pad and the flank.

6. The semiconductor package according to any preceding claim, wherein the plurality of terminals further comprises a third array of terminals, disposed along a third side of the semiconductor package, and a fourth array of terminals, disposed along a fourth side of the semiconductor package, wherein the fourth side opposes the third side.

7. The semiconductor package according to any preceding claim, wherein a thickness of the flank is equal to a thickness of the terminals.

8. A method of manufacturing a batch of semiconductor packages, comprising:
coupling a plurality of dies to a plurality of die paddles, the plurality of die paddles being provided on a lead frame in an array, wherein each die paddle defines a respective semiconductor package, and coupling the plurality of dies to a plurality of terminals on the plurality of die paddles, the terminals corresponding to each die paddle comprising at least a first array of terminals, disposed along a first side of each semiconductor package, and a second array of terminals, disposed along a second side of the semiconductor package, wherein the second side opposes the first side;
providing a fused encapsulant over the plurality of semiconductor packages, the fused encapsulant at least partly surrounding the array;
removing a first portion of the fused encapsulant, and a first portion of a connecting bar of the lead frame extending between terminals of respective arrays of terminals of each semiconductor package, by a first removal operation, to expose a flank of the terminals whilst the terminals remain electrically connected to one another;
plating at least part of the pads, including at least part of the exposed flank, using a plating process;
removing a second portion of the fused encapsulant, and a second portion of the connecting bar, by a second removal operation, to isolate the terminals within each array of terminals and to define recesses between each isolated terminal of each of the first and second arrays of terminals; and
cutting the fused encapsulant at a plurality of positions to singulate the semiconductor packages from the array.

9. The method according to claim 8, wherein removing the second portion of the connecting bar comprises removing the remainder of the connecting bar.

10. The method according to claims 8 or 9, wherein one or more of the first and second removal operations comprises one or more of a laser cutting, water jetting, sawing or chemical etching process.

11. The method according to any one of claims 8 to 10, wherein coupling the plurality of dies to the plurality of terminals comprises using a wirebonding process.

12. The method according to any one of claims 8 to 11, wherein removing a first portion of the connecting bar comprises severing a fused connecting bar, the fused connecting bar extending between a second array of terminals of a first semiconductor package, and a first array of terminals of an adjacent second semiconductor package.

13. The method according to any one of claims 8 to 12, wherein the first removal operation comprises removing material in a plurality of intermittent, elongate regions.

14. The method according to any one of claims 8 to 13, wherein the plurality of die paddles further comprises a third array of terminals, disposed along a third side of each semiconductor package, and a fourth array of terminals, disposed along a fourth side of each semiconductor package, wherein the fourth side opposes the third side.

15. A lead frame for manufacturing semiconductor packages, comprising:
an array of die paddles, wherein each die paddle defines a respective semiconductor package;
a plurality of terminals disposed around each die paddle, each plurality of terminals comprising a first array of terminals, disposed along a first side of the die paddle, and a second array of terminals, disposed along a second side of the die paddle, wherein the second side opposes the first side, each of the plurality of terminals comprising a pad with a flank;
wherein the terminals within each first array of terminals are electrically connected to one another by a first connecting bar, the first connecting bar extending directly between the terminals;
wherein the terminals within each second array of terminals are electrically connected to one another by a second connecting bar, the second connecting bar extending directly between the terminals;
wherein adjacent die paddles are electrically connected to one another by one or more of the first and second connecting bars.
